Europäisches Patentamt

European Patent Office

Office européen des brevets

(19)

(11) Veröffentlichungsnummer: **0 170 002**
A2

(12) ## EUROPÄISCHE PATENTANMELDUNG

(21) Anmeldenummer: 85106664.7

(22) Anmeldetag: 30.05.85

(51) Int. Cl.⁴: **B 30 B 3/04**

(30) Priorität: 01.06.84 DE 3420409

(43) Veröffentlichungstag der Anmeldung:
05.02.86 Patentblatt 86/6

(84) Benannte Vertragsstaaten:
AT BE CH DE FR GB IT LI NL SE

(71) Anmelder: HOECHST AKTIENGESELLSCHAFT
Postfach 80 03 20
D-6230 Frankfurt am Main 80(DE)

(72) Erfinder: Kühnert, Hans-Günter Egbert
Lerchenweg 8
D-6106 Erzhausen(DE)

(54) Laminierstation.

(57) Die Laminierstation umfaßt feststehende Teile 6,6' und beweglich gelagerte Teile 7,7', die mit einem Torsionsrohr 4 und einer Laminierwalze 2 eine Parallelschwinge bilden. In Seitenteilen 8, 9 der Laminierstation sind zwei Laminierwalzen 2, 3 und darunter das Torsionsrohr 4 und ein Abstandsrohr 5 angeordnet. Der Spalt zwischen den beiden Laminierwalzen 2, 3 ist einstellbar und die beweglichen Teile sind um das Torsionsrohr 4 als Achse verschwenkbar. Der Laminierdruck zwischen den beiden Laminierwalzen 2, 3 wird mittels einer oder zweier Stellschrauben 18 und zugehörigen Voreinstellschrauben 23, 23' festgelegt. Die Spitzen der Stellschrauben 18 drücken auf die Voreinstellschrauben 23, 23', die von Druckfedern 25, 25' umgeben in Gehäusen 19, 19' eingeschlossen sind, die unterhalb von Bünden 16, 16' der beweglichen Teile 7, 7' der Laminierstation angeordnet sind.

EP 0 170 002 A2

./...

FIG. 1

HOECHST AKTIENGESELLSCHAFT
KALLE Niederlassung der Hoechst AG

84/K 752                    - 1 -                21. Mai 1985
                                                WLK-DI.Z.-is

## Laminierstation

Die Erfindung betrifft eine Laminierstation mit zwei beheizten Laminierwalzen, zwischen denen ein Spalt einstellbar ist.

Schichtträger, wie beispielsweise Multilayerschichten, Metallplatten, Trägerplatten für gedruckte Schaltungen u. dgl. werden nach dem Säubern, Waschen und Trocknen einer Laminierstation bzw. einer Filmaufwalzeinrichtung zugeführt, in der auf die sich gegenüberliegenden Seiten eines Schichtträgers ein Film unter Druck und Wärme auflaminiert wird.

Aus den offengelegten europäischen Patentanmeldungen 0 040 842, 0 040 843 und 0 041 642 sind Laminiervorrichtungen bekannt, bei denen ein Substrat bzw. ein Schichtträger beidseitig unter Druckanwendung mit einem Trockenresist laminiert wird. Der Trockenresist wird für die jeweilige zu laminierende Seite des Schichtträgers, beispielsweise einer Trägerplatte für gedruckte Schaltungen, von einer Vorratsrolle abgezogen und einem Paar von Laminierwalzen zugeführt, durch deren Spalt die beiden Trockenresistfilme und der dazwischen befindliche Schichtträger hindurchlaufen. Vor dem Laminieren wird auf die Oberfläche des Schichtträgers bzw. die Trägerplatte für gedruckte Schaltungen eine dünne Flüssigkeitsschicht aufgebracht, die eine Zwischenschicht zwischen der Oberfläche der Trägerplatte und dem jeweiligen Trockenresistfilm während des Laminie-

HOECHST AKTIENGESELLSCHAFT
KALLE Niederlassung der Hoechst AG

- 2 -

rens bildet. Diese dünne Flüssigkeitsschicht wird von der Oberfläche der Leiterplatte durch Absorption in den Trockenresistfilm während des Laminierens entfernt.

Die US-PS 4,214,936 betrifft eine Laminiervorrichtung, bei der horizontal transportierte Platten, die kontinuierlich vorwärtsbewegt und kontaktbeheizt werden, beidseitig laminiert werden, wobei die Umfangsgeschwindigkeit der Laminierwalzen größer als die Vorschubgeschwindigkeit der Platten ist. Sobald ein Sensor die Hinterkante der vorgeheizten Platte kurz vor dem Eintritt in den Spalt zwischen den Laminierwalzen feststellt, werden diese erst nach einer gewissen Verzögerungszeit gestoppt, die es ermöglicht, daß die Hinterkante der Platte den Laminierspalt passiert. Wird die Vorderkante der nachfolgende Platte festgestellt, beginnen die Laminierwalzen von neuem zu rotieren und die in den Spalt eintretende Platte wird laminiert.

Aus der europäischen Patentanmeldung 0 058 421 ist eine Laminierstation mit zwei Laminierwalzen bekannt, die beide über Kettenzahnräder von dem gleichen Motor angetrieben werden. Sowie sich eine zu laminierende Platte den Laminierwalzen nähert, wird die Vorderkante der Platte von einem Sensor erfaßt, dessen Signal den Antriebsmotor für die Laminierwalzen in Bewegung setzt. Ein Signal eines zweiten Sensors, der die Vorderkante der Platte erfaßt, löst das Schließen der Laminierwalzen aus. Die Laminierwalzen schließen zu dem Zeitpunkt, zu dem die Vorderkante der Platte den Spalt zwischen

- 3 -

den Walzen erreicht. Wenn die Hinterkante der Platte einen weiteren Sensor passiert, wird ein Signal erzeugt, das die Laminierwalzen wieder öffnet. Das Öffnen und Schließen der Laminierwalzen erfolgt mittels eines Kurbelmechanismus.

In der US-PS 4 214 936 ist eine Laminierstation aus zwei beheizten Laminierwalzen beschrieben, von denen die obere Laminierwalze durch einen pneumatischen Druckzylinder gegen die feststehende untere Walze gedrückt wird. Der Druckzylinder übt auf die beiden Enden der beweglichen Achse der oberen Laminierwalze eine entsprechende Druckkraft in der Größenordnung von etwa 25 N aus. Ein Sensor erfaßt die Vorderkante einer zu laminierenden Platte, die zu der Laminierstation hintransportiert wird. Das Signal des Sensors versetzt die Laminierwalzen in Rotation. Die Platte sowie die beidseitig aufzulaminierenden Trockenresistfilme drücken den Spalt zwischen den Laminierwalzen auf, so daß diese Materialien hindurchlaufen können.

Bei den bekannten Laminierstationen ist entweder ein festvorgegebener Spalt zwischen den Laminierwalzen vorhanden oder es werden die Laminierwalzen pneumatisch mit vorbestimmter Druckkraft zusammengedrückt und erst durch den Verbund, bestehend aus einer Platte und den aufzulaminierenden Filmen, spaltbreit auseinandergedrückt, um den Verbund zwischen den Laminierwalzen hindurchtransportieren zu können. Es ist offensichtlich, daß bei Materialdicken des Verbunds, die bei-

HOECHST AKTIENGESELLSCHAFT
KALLE Niederlassung der Hoechst AG

- 4 -

spielsweise im Bereich von 0,5 bis 7 mm liegen können, Probleme beim Auseinanderdrücken der Laminierwalzen entstehen können und daß bei unterschiedlichen Materialdicken es nicht immer zweckmäßig ist, mit konstantem Laminierdruck für alle Materialdicken zu arbeiten, wie er in den bekannten Laminierstationen ausgeübt wird. Ändert sich die Dicke des Verbunds aus Platte und Resistfilmen oder sind für unterschiedliche Materialeigenschaften verschiedene Laminierdrücke erforderlich, so sind bei den bekannten Laminierstationen zeitraubende Umrüstungsarbeiten vorzunehmen, um den Spaltabstand der Laminierwalzen durch Ausbauen und Neuadjustieren zumindest einer der Laminierwalzen zu verändern bzw. ist eine Veränderung des Arbeitsdruckes des pneumatischen Zylinders oder auch dessen Auswechseln gegen einen Pneumatikzylinder mit anderer Kennlinie notwendig, um einen geänderten Laminierdruck der Walzen auf den Verbund aus Platte und Resistfilmen aufbringen zu können.

Bei bekannten Laminierstationen ergibt sich auch das Problem, daß häufig die eine Laminierwalze nicht in jeder Lage und bei jedem Spaltabstand exakt parallel zu der anderen Laminierwalze gelagert ist, was bewirkt, daß Schichtträger, wie z.B. Leiterplatten, beim Durchlaufen des Spalts zwischen den Laminierwalzen eine geringe Verdrehung erfahren, so daß längere Filmbahnen nicht parallel zu den Schichtträgerkanten in Durchlaufrichtung auflaminiert werden können.

Demgegenüber ist es die Aufgabe der Erfindung, eine Laminierstation zu schaffen, die in zeitsparender Weise ohne Umrüstungsarbeiten eine Änderung des Spalts zwischen den Laminierwalzen und/oder eine Veränderung des Laminierdrucks, der von den Laminierwalzen auf den Verbund ausgeübt wird, ermöglicht und bei der eine Spaltänderung zwischen den Laminierwalzen, die auf einer Seite vorgenommen wird, mit großer Genauigkeit auf die andere Seite der Laminierwalzen übertragen wird.

Diese Aufgabe wird erfindungsgemäß dadurch gelöst, daß die eine Laminierwalze und ein Torsionsrohr in beweglichen Teilen, die andere Laminierwalze und ein Abstandsrohr in feststehenden Teilen der Laminierstation gelagert sind und daß die eine Laminierwalze, das Torsionsrohr und die beiden beweglich gelagerten Teile eine Parallelschwinge bilden, deren Anpreßdruck auf einen zu laminierenden Schichtträger einstellbar ist.

In Ausgestaltung der Erfindung sind die Laminierwalzen oberhalb des Torsions- und des Abstandsrohres angeordnet und sind die beweglichen Teile um das Torsionsrohr als Achse, das in Seitenwänden eines Rahmens gelagert ist, verschwenkbar. Für die Festlegung des Spaltes zwischen den Laminierwalzen ist zumindest eine Einstelleinrichtung vorhanden, die mit einem der feststehenden Teile im Eingriff ist und gegen die der entsprechende bewegliche Teil anliegt bzw. die mit einem der beweglichen Teile im Eingriff ist und gegen die

HOECHST AKTIENGESELLSCHAFT
KALLE Niederlassung der Hoechst AG

- 6 -

der entsprechende feststehende Teil anliegt. Die Einstelleinrichtung ist zweckmäßigerweise eine Stellschraube, die in den feststehenden Teil horizontal eingeschraubt ist, und der bewegliche Teil der Laminierstation liegt gegen den Schraubenkopf der Stellschraube an.

Die vorteilhafte Weiterbildung der Erfindung ergibt sich aus den Merkmalen der dem Patentanspruch 4 folgenden Patentansprüche.

Die Erfindung wird im folgenden anhand von zeichnerisch dargestellten Ausführungsbeispielen näher beschrieben.

Es zeigen:

Fig. 1 eine Seitenansicht, teilweise aufgebrochen, einer ersten Ausführungsform der Laminierstation nach der Erfindung,

Fig. 2 eine Schnittansicht der beweglichen Teile der Laminierstation, mit einem in den Seitenwänden gelagerten Torsionsrohr nach Fig. 1,

Fig. 3 eine perspektivische Ansicht einer zweiten Aufführungsform der Laminierstation, mit dem Antriebsmotor und dem Zahnradgetriebe,

Fig. 4 eine Schnittansicht der Laminierstation nach Fig. 3, und

HOECHST AKTIENGESELLSCHAFT
KALLE Niederlassung der Hoechst AG

- 7 -

Fig. 5    Einzelheiten der beweglichen Teile der Laminierstation.

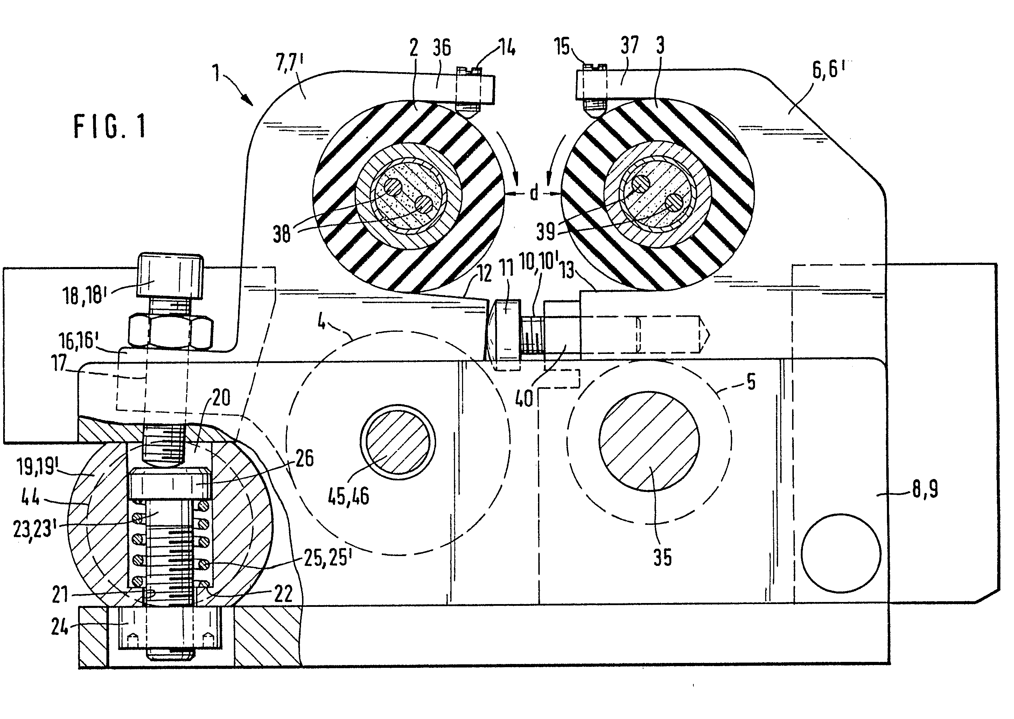

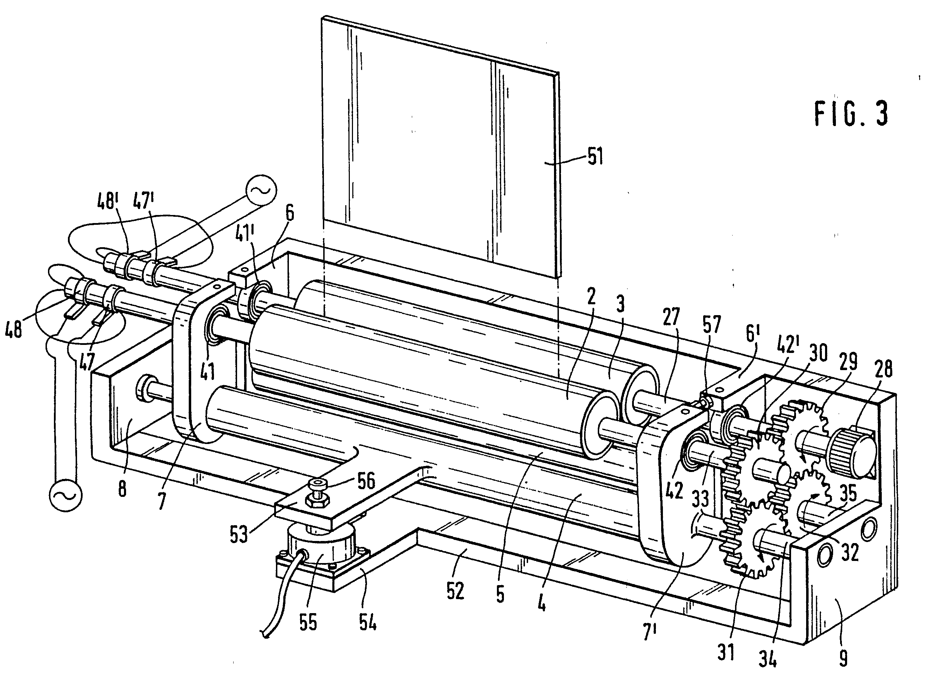

Die in Fig. 1 in Seitenansicht dargestellte Laminierstation 1 umfaßt feststehende Teile 6,6' und beweglich
gelagerte Teil 7,7', die zusammen mit einer Laminierwalze 2 und einem Torsionsrohr 4 als Parallelschwinge
ausgebildet sind und die Laminierwalze 2 mit einem bestimmten Anpreßdruck auf einen nichtgezeigten, zu laminierenden Schichtträger drücken, der durch den
Spalt d zwischen zwei Laminierwalzen 2 und 3 hindurchtransportiert wird. Die Teile 6,6' und 7,7' liegen
symmetrisch zu der Mitte der Laminierstation 1, wie
aus dem Ausführungsbeispiel nach Fig. 3 ersichtlich
ist. In Fig. 1 ist jeweils nur einer der beiden Teile
in der Ansicht zu erkennen. Unterhalb der Laminierwalzen 2 und 3 sind das Torsionsrohr 4 und ein Abstandsrohr 5 in Seitenwänden 8,9 (vgl. Fig. 3), von denen in
Fig. 1 nur die vordere Seitenwand 8 sichtbar ist, der
Laminierstation 1 gelagert. Die Umfangsgeschwindigkeit
der Laminierwalzen 2 und 3 ist im allgemeinen größer
als die Transportgeschwindigkeit des Schichtträgers,
der von einer nichtdargestellten Heizvorrichtung von
obenher und vertikal ausgerichtet den beiden Laminierwalzen 2 und 3 zugeführt wird. Die Laminierwalze 3 ist
ortsfest in den feststehenden Teilen 6,6' gelagert,
während die Laminierwalze 2 ortsfest in den beweglichen Teilen 7,7' gelagert ist, durch deren Bewegung
eine Veränderung des Spalts d zwischen den Laminierwalzen in vorgegebenen Grenzen möglich ist. Der talen Oberteilen 36 und 37 der Teile 7,7' bzw. 6,6' sind vertikale Gewindelöcher vorgesehen, in die Schrauben 14 und 15 eingeschraubt sind, welche mit ihren konischen Spitzen gegen die Laminierwalze 2 bzw. 3 anliegen und diese gegen seitliches Verschieben aus den Backen heraus arretieren.

An der Außenseite des einen beweglichen Teils 7 der Parallelschwinge ist in Fig. 1 ein Bund 16 zu erkennen, der ein durchgehendes Gewindeloch 17 enthält, in das eine Stellschraube 18 eingeschraubt ist. Unterhalb des Bundes 16 befindet sich ein kugel- oder rohrförmiges Gehäuse 19, das parallel zu dem Torsions- bzw. Abstandsrohr 4 bzw. 5 angeordnet ist. Das Gehäuse 19 ist oben und unten abgeflacht und weist in den abgeflachten Bereichen Durchgangslöcher 20 und 21 auf. Das Gehäuse 19 umschließt eine Voreinstellschraube 23, die das untere Durchgangsloch 21 durchsetzt und mit einer Schraubmutter 24 im Eingriff ist, die an der Außenseite des unteren abgeflachten Bereichs des Gehäuses 19 anliegt und die Voreinstellschraube 23 gegen die Federkraft einer Druckfeder 25 in ihrer Lage hält. Die Druckfeder 25 umgibt den Schaft der Voreinstellschraube 23 und liegt mit ihrem unteren Ende in einem Sackloch 22, das im Gehäuseboden angebracht ist und mit ihrem oberen Ende gegen die Unterseite eines Schraubenkopfes 26 der Voreinstellschraube 23 an. Die Spitze der Stellschraube 18 liegt auf der Oberseite des Schraubenkopfs 26 auf. Wegen der Symmetrie der Parallelschwinge weist der andere bewegliche Teil 7'

0170002

HOECHST AKTIENGESELLSCHAFT
KALLE Niederlassung der Hoechst AG

- 10 -

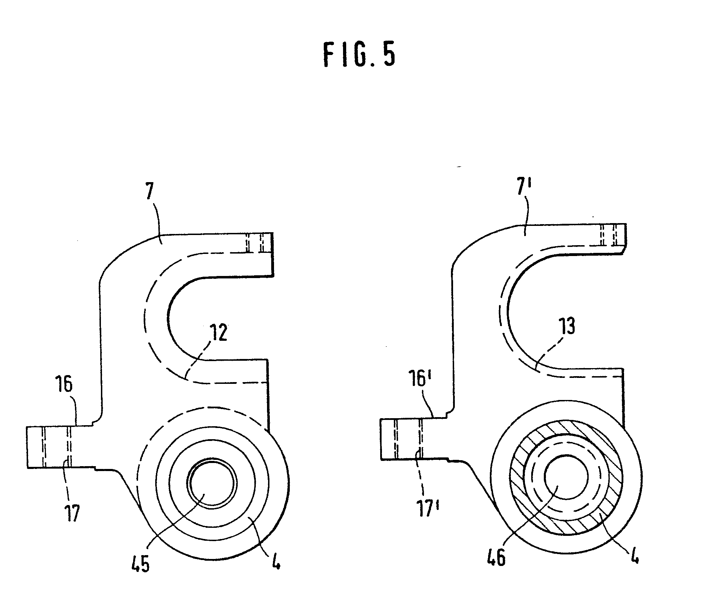

einen Bund 16' mit einem Gewindeloch 17' auf, wie
Fig. 5 zeigt. Eine Voreinstellschraube 23' ist von
einer Feder 15' umgeben. Die symmetrisch zur Mitte
liegenden Gehäuse 19,19' verbindet ein Abstandsrohr 44
miteinander.

Mit Hilfe der Stellschrauben 18,18', in Fig. 1 und der
Voreinstellschrauben 23,23', die von Federn 25 bzw.
25' umgeben sind sowie der Schraubenmuttern 24 bzw.
24' wird die Kraft voreingestellt, die für ein Verschwenken der Parallelschwinge der Laminierstation erforderlich ist. Im folgenden ist nur jeweils auf einen
Teil Bezug genommen, wobei vorausgesetzt wird, daß der
dazu symmetrisch liegende Teil in gleicher Weise betätigt und wirksam wird. Wird die Schraube 18 in
Fig. 1 weiter in das Gewindeloch 17 eingeschraubt,
wird dementsprechend die Feder 25 durch die nach unten
gedrückte Voreinstellschraube 23 stärker zusammengedrückt und durch entsprechendes Nachstellen der
Schraubenmutter 24 in der gewünschten Lage gehalten.
Je stärker die Feder 25 zusammengedrückt ist, desto
größer ist die aufzubringende Kraft, um die Parallelschwinge aus ihrer Position nach außen zu verschwenken. Mit anderen Worten bedeutet dies, daß der Laminierdruck, der von der Laminierwalze 2 auf den
Schichtträger bei seinem Durchlaufen des Spalts d der
Laminierwalzen 2 und 3 ausgeübt wird, umso größer ist,
je stärker die Federn 25,25' zusammengedrückt sind.
Die Federn 25,25', es handelt sich um Druckfedern, besitzen im allgemeinen eine lineare Kennlinie, können jedoch auch eine davon abweichende Kennlinie aufweisen.

Die beweglichen Teile 7,7' bilden die Parallelschwinge aus dem Torsionsrohr 4 und der Laminierwalze 2, die sicherstellt, daß bei einer Spaltvergrößerung eine rein parallele Verstellung der beweglichen Laminierwalze 2 gegenüber der fest verankerten Laminierwalze 3 erfolgt. Das Torsionsrohr 4 überträgt völlig gleichmäßig über seine Gesamtlänge das Verschwenken der beweglichen Laminierwalze 2, so daß ein durchgehend konstanter Spalt erhalten wird. Des weiteren gewährleisten die beiden fest gelagerten Zahnräder 31 und 32, wobei das dritte Zahnrad 31 auch bei einem Verschwenken der Laminierwalze 2 im Eingriff mit dem zweiten Zahnrad 30 verbleibt, daß die gleiche Drehgeschwindigkeit, wie sie die fest verankerte Laminierwalze 3 durch den Motor 28 erhält, über die Zahnräder 29,32,31 und 30 der verschwenkten Laminierwalze 2 erteilt wird, auch wenn das erste Zahnrad 29 mit dem zweiten Zahnrad 30 außer Eingriff ist. Dadurch ist stets die gleiche Umfangsgeschwindigkeit der beiden Laminierwalzen 2 und 3 sichergestellt.

Fig. 2 zeigt im Schnitt eine Ansicht der Parallelschwinge der Laminierstation. Wie aus der Zeichnung ersichtlich ist, ist das Torsionsrohr 4 in den Seitenwänden 8 und 9 gelagert. Die Steckachse 46 erstreckt sich über die Seitenwand 9 hinaus, während die Steckachse 45 bündig mit der Seitenwand 8 abschließt. Ober-

H O E C H S T   A K T I E N G E S E L L S C H A F T
KALLE   Niederlassung der Hoechst AG

- 12 -

halb des Torsionsrohres 4 befinden sich in den Teilen
7 und 7' die Kugellageraufnahmen 12 und 13 für Kugellager 41,42, die auf den Wellenenden der Laminierwalze 2 aufsitzen. Die Kugellageraufnahme 12 in dem Teil
7 ist abgestuft ausgebildet, wobei die Öffnung mit dem
größeren Radius der Innenseite und die Öffnung mit dem
kleineren Radius der Außenseite des Teils 7 zugewandt
ist. In dem Teil 7' ist die Kugellageraufnahme 13 hinterschnitten und hat den gleichen Durchmesser wie die
größere der beiden Öffnungen in dem Teil 7. Die Kugellageraufnahme 12 besitzt in Achsenrichtung der Laminierwalze 2 ein Spiel, das den Ausgleich von Fertigungstoleranzen beim Einbau der Laminierwalze 2 in die
Teile 7,7' zuläßt.

Auf der Welle 33 der Laminierwalze 2 sitzt ein Zahnrad
30 auf, das mit einem Zahnrad 31 kämmt, welches auf
einem abgesetzten Ende des Torsionsrohres 4 angeordnet
ist. Die Zahnräder 30 und 31 befinden sich zwischen
den Außenflächen des Teils 7' der Parallelschwinge und
der Innenfläche der Seitenwand 9. Auf der über die
Seitenwand 9 hinaus verlängerten Welle 33 der Laminierwalze 2 sind Schleifklemmen 47,48 für die Stromzufuhr
zum Aufheizen der Laminierwalze 2 angebracht. Sowohl
die verlängerte Welle 33 als auch die verlängerte Torsionsachse 34 des Torsionsrohrs 4 sind in dem Seitenteil eines nicht dargestellten Rahmens gelagert.

Das Torsionsrohr 4 ist mittels Stiften 49,50, wie beispielsweise eingeschlagenen Kegelstiften, mit den Tei-

HOECHST AKTIENGESELLSCHAFT
KALLE Niederlassung der Hoechst AG

- 14 -

nicht dargestellt ist, kann auch noch eine weitere derartige Einstelleinrichtung zwischen dem beweglichen Teil 7 und dem feststehenden Teil 6 wirken. Die Einstelleinrichtung 57 ist im oberen Bereich der Teile 6' und 7' und oberhalb der Laminierwalzen 2,3 angeordnet und erleichtert die Spalteinstellung im Vergleich zu den Einstelleinrichtungen 10,10' in Fig. 1, die sich unterhalb der Laminierwalzen 2,3 befinden und daher schwerer zugänglich sind.

Die Lagerung der Wellen 27,33 der Laminierwalzen 2,3 erfolgt durch Kugellager 41',42' bzw. 41,42 in den Teilen 6,6' bzw. 7,7'.

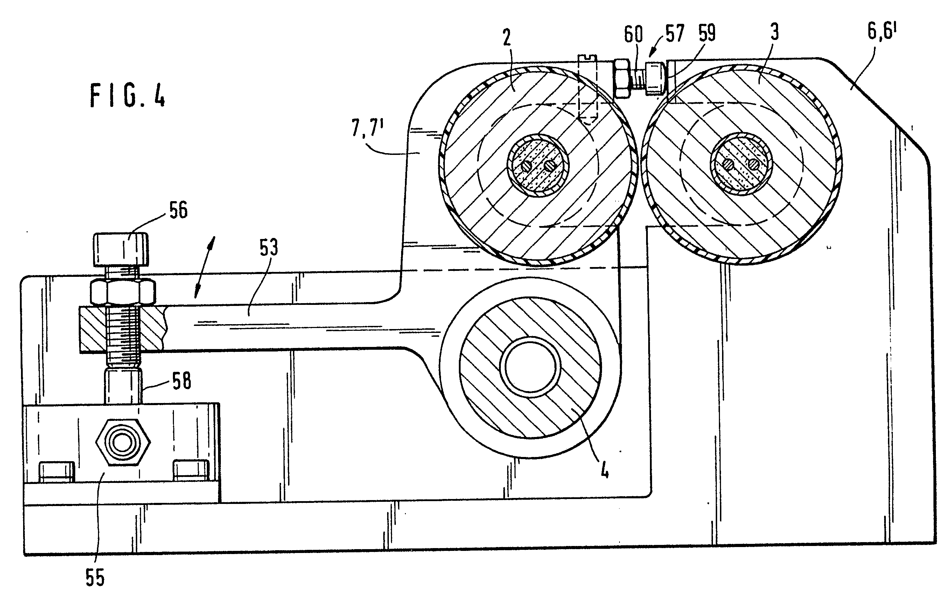

Die Parallelschwinge wird bei dieser Ausführungsform mittels eines Pneumatikzylinders 55 verschwenkt, der auf einem Vorsprung 54 der Grundplatte des Rahmens 52 befestigt ist und dessen Zylinderkolbenstange 58, wie insbesondere Fig. 4 zeigt, gegen eine gekonterte Einstellschraube 56 anliegt, die sich durch einen Hebelarm 53 erstreckt. Der Hebelarm 53 ist mittig mit dem Torsionsrohr 4 verbunden, beispielsweise an diesem angeschweißt. Die Wirkungsweise des Pneumatikzylinders 55 entspricht derjenigen einer pneumatischen Feder, die den Hebelarm 53 mit konstantem Druck nach oben drückt und die Parallelschwinge aus Laminierwalze 2, Torsionsrohr 4 und beweglichen Teilen 7,7' bis zum Anliegen der Stellschraube 60 der Einstelleinrichtung 57 an einer Anschlagfläche 59 des feststehenden Teils 6' verschwenkt. Der in den Spalt zwischen den Laminier-

- 15 -

walzen 2,3 einlaufende Schichtträger ist geringfügig dicker als der Spalt und drückt die Laminierwalze 2 und damit die Parallelschwinge halbkreisförmig nach links unten in Fig. 4, so daß der Hebelarm 53 nach unten verschwenkt wird und die Einstellschraube 56 die Zylinderkolbenstange 58 so weit in den Pneumatikzylinder 55 hineindrückt, bis sich ein Gleichgewicht zwischen dem Zylinderdruck und dem von der Parallelschwinge über den Hebelarm 53 ausgeübten Druck auf die Zylinderkolbenstange einstellt. In diesem Gleichgewichtszustand wird ein ausreichender Laminierdruck von der Laminierwalze auf den Schichtträger ausgeübt.

Auf einer Welle 27 der in den feststehenden Teilen 6,6' mittels Kugellagern 41',42' gelagerten Laminierwalze 3 sitzt ein Motor 28 auf, der die Laminierwalze 3 antreibt. Zwischen dem Teil 6' und dem Motor 28 befindet sich ein erstes Zahnrad 29 auf der Welle 27. Auf der Welle 33 der Laminierwalze 2, die mit Hilfe der Kugellager 41,42 in den beweglichen Teilen 7,7 der Laminierstation gelagert ist, sitzt das zweite Zahnrad 30 auf. Unterhalb der Laminierwalzen 2 und 3 befinden sich das Torsionsrohr 4 und das Abstandsrohr 5. Die Torsionsachse 34 trägt das dritte Zahnrad 31 und ein Bolzen 35, der im Teil 6' und in der Seitenwand 9 gelagert ist, ein viertes Zahnrad 32. Die Zahnräder 31 und 32 kämmen miteinander und des weiteren kämmt das dritte Zahnrad 31 mit dem zweiten Zahnrad 30 und das vierte Zahnrad 32 mit dem ersten Zahnrad 29.

HOECHST AKTIENGESELLSCHAFT
KALLE Niederlassung der Hoechst AG

- 16 -

Fig. 5 zeigt die beiden beweglichen Teile 7,7' der Laminierstation 1. Die beiden Teile 7 und 7' sind in ihren Umrissen nahezu identisch und weisen die nach außen vorspringenden Bünde 16 bzw. 16' auf, die von den Gewindelöchern 17 bzw. 17' vertikal durchsetzt werden. Die zangenförmige Kugellageraufnahme 12 in dem Teil 7 nimmt das eine Ende der Laminierwalze 2 auf. Der Durchmesser des größeren der beiden eingezeichneten Halbkreise der zangenförmigen Kugellageraufnahme ist so groß wie der Durchmesser des gestrichelt eingezeichneten Kreises der zangenförmigen Kugellageraufnahme 13 des Teils 7'. Unterhalb der Kugelllageraufnahmen 12 und 13 sind in den Teilen 7 und 7' die Steckachsen 45 und 46 (vgl. Fig. 2) und das Torsionsrohr 4, das in den Seitenwänden 8 und 9 mit Hilfe der Steckachsen 45 und 46 gelagert ist und über die Seitenwand 9 hinausragt, angedeutet.

---

HOECHST AKTIENGESELLSCHAFT
KALLE  Niederlassung der Hoechst AG

84/K 752                    - 17 -            21. Mai 1985
                                              WLK-DI.Z.-is

Patentansprüche

1. Laminierstation mit zwei beheizten Laminierwalzen, zwischen denen ein Spalt einstellbar ist, dadurch gekennzeichnet, daß die eine Laminierwalze (2) und ein Torsionsrohr (4) in beweglichen Teilen (7,7'), die andere Laminierwalze (3) und ein Abstandsrohr (5) in feststehenden Teilen (6,6') der Laminierstation (1) gelagert sind und daß die eine Laminierwalze (2), das Torsionsrohr (4) und die beiden beweglich gelagerten Teile (7,7') eine Parallelschwinge bilden, deren Anpreßdruck auf einen zu laminierenden Schichtträger einstellbar ist.

2. Laminierstation nach Anspruch 1, dadurch gekennzeichnet, daß die Laminierwalzen (2,3) oberhalb des Torsions- und des Abstandsrohres (4,5) angeordnet sind und daß die beweglichen Teile (7,7') um das Torsionsrohr (4) als Achse, das in Seitenwänden (8,9) eines Rahmens (52) gelagert ist, verschwenkbar sind.

3. Laminierstation nach Anspruch 1, dadurch gekennzeichnet, daß für die Festlegung des Spaltes zwischen den Laminierwalzen (2,3) zumindest eine Einstelleinrichtung (10,10';57) vorhanden ist, die mit einem der feststehenden Teile (6,6') im Eingriff ist und gegen die der entsprechende bewegliche Teil (7 bzw. 7') anliegt bzw. die mit einem der beweglichen Teile (7,7') in Eingriff ist und gegen die der entsprechende feststehende Teil anliegt.

HOECHST  AKTIENGESELLSCHAFT
KALLE  Niederlassung der Hoechst AG

- 18 -

4. Laminierstation nach Anspruch 3, dadurch gekennzeichnet, daß die Einstelleinrichtung (10,10') eine Stellschraube ist, die in den feststehenden Teil (6 bzw. 6') horizontal eingeschraubt ist und daß der bewegliche Teil (7 bzw. 7') der Laminierstation (1) gegen den Schraubenkopf (11) der Stellschraube anliegt.

5. Laminierstation nach Anspruch 1, dadurch gekennzeichnet, daß die beweglichen Teile (7,7') der Parallelschwinge je eine zangenförmige Kugellageraufnahme (12,13) aufweisen und daß Schrauben (14,15), welche die horizontalen Oberteile (36,37) der Teile (7,7';6,6') ) vertikal durchsetzen, die Laminierwalzen (2,3) gegen seitliches Verschieben aus den Kugellageraufnahmen heraus sichern.

6. Laminierstation nach Anspruch 5, dadurch gekennzeichnet, daß die beweglichen Teile (7,7') der Parallelschwinge je einen Bund (16 bzw. 16') aufweisen, der ein durchgehendes Gewindeloch (17 bzw. 17') enthält, in das eine Stellschraube (18,18') eingeschraubt ist.

7. Laminierstation nach den Ansprüchen 5 und 6, dadurch gekennzeichnet, daß unterhalb der Bünde (16,16'), parallel zu dem Torsionsrohr (4), je ein kugel- oder rohrförmiges Gehäuse (19,19') angeordnet ist, das oben und unten abgeflacht ist und daß das Gehäuse (19,19') in den abgeflachten Bereichen Durchgangslöcher (20,21) aufweist.

HOECHST AKTIENGESELLSCHAFT
KALLE Niederlassung der Hoechst AG

- 19 -

8. Laminierstation nach Anspruch 7, dadurch gekennzeichnet, daß oberhalb des unteren Durchgangsloches (21) ein Sackloch (22) im Gehäuseboden angebracht ist und daß im Inneren des Gehäuses (19,19') eine Voreinstellschraube (23,23') vorhanden ist, die das untere Durchgangsloch (21) durchsetzt und mit einer Schraubenmutter (24,24') im Eingriff ist, die an der Außenseite des unteren abgeflachten Bereiches des Gehäuses (19,19') anliegt.

9. Laminierstation nach Anspruch 8, dadurch gekennzeichnet, daß eine Feder (25,25') die Voreinstellschraube (23,23') umgibt, sich mit ihrem unteren Ende in dem Sackloch (22) gegen den Gehäuseboden und mit ihrem oberen Ende gegen die Unterseite des Schraubenkopfes (26) der Voreinstellschraube (23,23') abstützt.

10. Laminierstation nach den Ansprüchen 6 bis 9, dadurch gekennzeichnet, daß die Stellschraube (18,18') mit ihrer Spitze an der Oberseite des Schraubenkopfes (26) anliegt.

11. Laminierstation nach Anspruch 1, dadurch gekennzeichnet, daß ein Motor (28) die Welle (27) der in den feststehenden Teilen (6,6') gelagerten Laminierwalze (3) antreibt, daß auf der Welle (27) zwischen dem Motor (28) und einem der feststehenden Teile (6,6') ein Zahnrad (29) aufsitzt, daß ein Zahnrad (30) auf einer Welle (33) der in den beweglichen Teilen (7,7') gelagerten Laminierwalze (2) aufsitzt und daß die

- 21 -

Vorsprung (54) des Rahmens (52) unterhalb des Hebelarms (53) befestigt ist und während des Laminierbetriebs kontinuierlich unter Druck steht.

17. Laminierstation nach Anspruch 5, dadurch gekennzeichnet, daß die eine Laminierwalze (2) mittels
Kugellager (41,42) in den Kugellageraufnahmen (12,13)
der beweglichen Teile (7,7') und die andere Laminierwalze (3) mittels Kugellager (41',42') in den feststehenden Teilen (6,6') gelagert sind.

18. Laminierstation nach Anspruch 1, dadurch gekennzeichnet, daß auf den Endabschnitten der Wellen
(33,27) der Laminierwalzen (2,3) Schleifklemmen (47,48
bzw. 47',48') aufsitzen, die mit Stromquellen zum Aufheizen der Laminierwalzen (2,3) verbunden sind.

---

FIG. 1

0170002

FIG. 3

0170002

FIG. 4

FIG.5